(19) 

**Europäisches Patentamt**
**European Patent Office**
**Office européen des brevets**

(11)  **EP 2 003 478 A2**

(12) **EUROPEAN PATENT APPLICATION**
published in accordance with Art. 153(4) EPC

(43) Date of publication:
**17.12.2008 Bulletin 2008/51**

(51) Int Cl.:
*G02B 13/24* (2006.01)    *G02B 13/14* (2006.01)
*G02B 13/18* (2006.01)    *G03F 7/20* (2006.01)
*H01L 21/027* (2006.01)

(21) Application number: **07738688.6**

(22) Date of filing: **15.03.2007**

(86) International application number:
**PCT/JP2007/055238**

(87) International publication number:
**WO 2007/114024 (11.10.2007 Gazette 2007/41)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **03.04.2006 JP 2006101800**

(71) Applicant: **Nikon Corporation**
**Tokyo 100-8331 (JP)**

(72) Inventor: **OHMURA, Yasuhiro**
**Tokyo 100-8331 (JP)**

(74) Representative: **HOFFMANN EITLE**
**Patent- und Rechtsanwälte**
**Arabellastrasse 4**
**81925 München (DE)**

(54) **PROJECTION OPTICAL SYSTEM, ALIGNER, AND METHOD FOR FABRICATING DEVICE**

(57)    A refractive projection optical system in which a large image side numerical aperture can be ensured by interposing liquid in the optical path to the image plane, and an image having good planarity can be formed while suppressing radial upsizing. The projection optical system comprising a first image forming system (G1-G5) arranged in the optical path between a first plane (R) and a point optically conjugate to a point on the optical axis of the first plane, and a second image forming system (G6, G7) arranged in the optical path between the conjugate point and a second plane (W). In the projection optical system, all optical elements having power are refractive optical elements. The optical path between the projection optical system and the second plane is filled with liquid (Lm) having a refractive index larger than 1.3.

**Fig.4**

Printed by Jouve, 75001 PARIS (FR)

EP 2 003 478 A2

## Description

TECHNICAL FIELD

The present invention relates to a projection optical system, an exposure apparatus, and a device manufacturing method, and more particularly, to a projection optical system optimal for use in an exposure apparatus employed for manufacturing a device such as a semiconductor element or a liquid crystal display element in a photolithography process.

BACKGROUND ART

In a photolithography process for manufacturing a semiconductor element or the like, an exposure apparatus is used to project and expose a pattern image of a mask (or reticle) on a photosensitive substrate (wafer, glass plate, or the like that is coated with photoresist) via a projection optical system. In an exposure apparatus, the projection optical system is required to have a higher resolving power (resolution) as integration of semiconductor elements and the like becomes higher.

The wavelength $\lambda$ of the illumination light (exposure light) must be shortened and the image side numerical aperture NA of the projection optical system must be enlarged to satisfy the requirements for the resolving power of the projection optical system. More specifically, the resolution of the projection optical system is expressed by $k \cdot \lambda / NA$ (k being a process coefficient). Further, an image side numerical aperture NA is expressed by $n \cdot \sin\theta$ where the refractive index of a medium between the projection optical system and the photosensitive substrate (normally, a gas such as air) is represented by n, and the maximum incident angle to the photosensitive substrate is represented by $\theta$.

In this case, when enlarging the maximum incident angle $\theta$ to increase the image side numerical aperture, the incident angle to the photosensitive substrate and the exit angle from the projection optical system would increase and cause difficulties in aberration correction. Therefore, a large effective image side numerical aperture cannot be obtained unless the lens diameter is enlarged. Furthermore, since the refractive index of gas is about 1, the image side numerical aperture cannot be adjusted to 1 or greater. Accordingly, an immersion technique known in the art increases the image side numerical aperture by filling an optical path between the projection optical system and the photosensitive substrate with a medium having a high refractive index such as a liquid (for example, patent publication 1).

Patent Publication 1: International Patent Publication Pamphlet No. WO2004/019128

DISCLOSURE OF THE INVENTION

PROBLEMS TO BE SOLVED BY THE INVENTION

A refractive projection optical system, in which optical elements having power are all formed by refractive optical elements (lens, plane-parallel plate, or the like), is often applied to an exposure apparatus in the conventional art as a lithography projection optical system. Such an optical system is optimal for use in an exposure apparatus from the viewpoints of reliability and productivity. However, in a once imaging type refractive projection optical system of the conventional art, in order to obtain a large image side numerical aperture, the lens diameter must be enlarged to satisfy the Petzval condition and produce a flat image. As a result, in addition to the production of a lens having the required quality becoming difficult, the supporting of the lens in a manner avoiding deformation or displacement of the lens becomes difficult. Thus, costs cannot be reduced while maintaining satisfactory imaging performance.

Accordingly, it is an object of the present invention to provide a refractive projection optical system in which a liquid is arranged in an optical path between the refractive projection optical system and an image plane to obtain a large image side numerical aperture and which is able to form an image having satisfactory flatness while preventing enlargement in the radial direction. A further object of the present invention is to provide an exposure apparatus that projects and exposes fine patterns on a photosensitive substrate with high accuracy using a refractive liquid immersion projection optical system having a large image side numerical aperture and forming an image having satisfactory flatness.

SOLUTIONS FOR SOLVING THE PROBLEMS

To solve the above object, a first embodiment of the present invention provides a projection optical system that forms a reduced image of a first plane on a second plane. The projection optical system includes a first imaging system, which is arranged in an optical path between a first plane and a conjugation point optically conjugated to a point on an optical path of the first plane, and a second imaging system, which is arranged in an optical path between the conjugation point and the second plane. Optical elements having power in the projection optical system are all refractive optical elements. With gas in the optical path of the projection optical system having a refractive index of 1, the optical path between the projection optical system and the second plane is filled with liquid having a refractive index of 1.3 or greater.

A second embodiment of the present invention provides an exposure apparatus including the projection optical system of the first embodiment which projects an image of a predetermined pattern set at the first plane onto a photosensitive substrate set at the second plane based on light from the pattern.

A third embodiment of the present invention provides a device manufacturing method including an exposure step for exposing the predetermined pattern onto the photosensitive substrate using the exposure apparatus of the second embodiment and a development step for developing the photosensitive substrate that has undergone the exposure step.

EFFECT OF THE INVENTION

In the projection optical system of the present invention, for example, a twice-imaging type refractive structure is used. Thus, a Petzval sum can be corrected in a satisfactory manner and an image having satisfactory flatness can be obtained without adversely affecting the coma aberration and spherical aberration and without enlarging optical elements in the radial direction.

Further, the projection optical system of the present invention employs a liquid immersion type structure in which a liquid immersion area is formed at the image side. Thus, a relatively large effective imaging field can be obtained while obtaining a large effective image side numerical aperture.

In this manner, the present invention realizes a refractive projection optical system in which a liquid is arranged in an optical path between the refractive projection optical system and an image plane to obtain a large image side numerical aperture and which is able to form an image having satisfactory flatness while preventing enlargement in the radial direction. Further, in the exposure apparatus of the present invention, a refractive liquid immersion projection optical system having a large image side numerical aperture and forming an image having satisfactory flatness is used to project and expose fine patterns on a photosensitive substrate with high accuracy.

BRIEF DESCRIPTION OF THE DRAWINGS

Fig. 1 is a schematic diagram showing the structure of an exposure apparatus according to one embodiment of the present invention;
Fig. 2 is a diagram showing the positional relationship of a rectangular static exposure region, which is formed on a wafer, and an optical axis in the present embodiment;
Fig. 3 is a schematic diagram showing the structure between a boundary lens and a wafer in the present embodiment;
Fig. 4 is a diagram showing a lens structure of a projection optical system in a first example of the present embodiment;
Fig. 5 is a diagram showing transverse aberration in the projection optical system of the first example;
Fig. 6 is a diagram showing a lens structure of a projection optical system in a second example of the present embodiment;
Fig. 7 is a diagram showing transverse aberration in the projection optical system of the second example;
Fig. 8 is a diagram showing a lens structure of a projection optical system in a third example of the present embodiment;
Fig. 9 is a diagram showing transverse aberration in the projection optical system of the third example;
Fig. 10 is a flowchart showing the procedures for obtaining a semiconductor device serving as a micro-device; and
Fig. 11 is a flowchart showing the procedures for obtaining a liquid crystal display element serving as a micro-device.

DESCRIPTION OF REFERENCE NUMERALS

R reticle
RST reticle stage
PL projection optical system
Lb boundary lens
Lm pure water (liquid)
W wafer
1 illumination optical system
9 Z stage
10 XY stage

13    wafer laser interferometer
14    main control system
15    wafer stage drive system
21    water supply/discharge mechanism

BEST MODE FOR CARRYING OUT THE INVENTION

A projection optical system according to the present invention is, for example, a twice-imaging type, liquid immersion, refractive optical system. More specifically, the projection optical system of the present invention includes a first imaging system, which is arranged in an optical path between an object plane (first plane) and a conjugation point optically conjugated to a point on an optical axis of the object plane, and a second imaging system, which is arranged in an optical path between the conjugation point and an image plane (second plane). That is, the first imaging system forms an intermediate image on or near the position of the conjugation point based on light from the object plane, and the first imaging system ultimately forms a reduced image on the image plane based on light from the intermediate image.

Further, in the projection optical system of the present invention, optical elements having power are all refractive optical elements (lens, plane-parallel plate, and the like). That is, the projection optical system of the present invention does not include reflection mirrors that have power and is mainly formed by a plurality of lenses. Additionally, in the present invention, the optical path between the projection optical system and the image plane is filled with liquid having a refractive index of 1.3 or greater (with gas in the optical path of the projection optical system having a refractive index of 1).

As described above, the projection optical system of the present invention employs, for example, a twice-imaging type and refractive structure. Thus, many locations in which the cross-section of a light beam is small may be obtained. As a result, a plurality of negative lens can be arranged in a concentrated manner at these locations to correct the Petzval sum in a satisfactory manner and obtain an image having satisfactory flatness without adversely affecting the coma aberration or spherical aberration and without enlarging optical elements such as lenses in the radial direction. Further, since the projection optical system of the present invention employs a liquid immersion type structure having a liquid immersion region formed at the image side, a relatively large effective imaging region can be obtained while obtaining a large effective image side numerical aperture.

In this manner, the projection optical system of the present invention arranges liquid in the optical path extending to the image plane and obtains a large image side numerical aperture. Thus, an image having satisfactory flatness can be formed while preventing enlargement in the radial direction. Further, in the exposure apparatus of the present invention, a refractive type liquid immersion projection optical system that has a large image side numerical aperture and forms an image having satisfactory flatness is used. Thus, fine patterns can be projected and exposed on a photosensitive substrate with high accuracy.

In the projection optical system of the present invention, it is preferable that the condition (1) shown below be satisfied. In condition (1), $\beta 1$ represents the imaging magnification of the first imaging system, and $\beta$ represents the projection magnification of the projection optical system.

$$5 < |\beta 1 / \beta| \qquad (1)$$

When the lower limit value of condition (1) is not met, the imaging magnification $\beta 1$ of the first imaging system becomes too small, correction of the Petzval sum without adversely affecting the coma aberration or the spherical aberration becomes difficult, and an image having satisfactory flatness cannot be formed. This is not preferable. To exhibit the effects of the present invention in a satisfactory manner, it is preferable that in condition (1) the lower limit value is set to 5.5 and the upper limit value be set to 12. When this upper limit value is not met, in order to decrease the field curvature, the lens diameter becomes large near the position at which an intermediate image is formed. This is not preferable.

Further, the projection optical system of the present invention includes, sequentially from the object side, a first lens group having positive refractive power, a second lens group having negative refractive power, a third lens group having positive refractive power, a fourth lens group having negative refractive power, a fifth lens group having positive refractive power, a sixth lens group having negative refractive power, and a seventh lens group having positive refractive power. In this manner, the employment of a seven-group structure having a refractive power arrangement of positive, negative, positive, negative, positive, negative, and positive sequentially from the object side enables effective refractive power arrangement that satisfies the Petzval condition and avoids lens enlargement.

In the projection optical system of the present invention, it is preferable that a conjugation point optically conjugated to a point on the optical axis of the object plane be located in an optical path between the third lens group and the seventh lens group. With this structure, in a reduction projection optical system having a projection magnification of 1/4 which exposure apparatuses mainly use, the arrangement of negative lenses for correcting the Petzval sum is simplified. For further simplification of the arrangement of negative lenses to correct the Petzval sum, it is preferred that the above conjugation point be located in an optical path between the fourth lens group and the sixth lens group.

Further, in the projection optical system of the present invention, it is preferable that the next conditions (2) to (4) be satisfied. In conditions (2) to (4), a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7. The maximum lens diameter of a lens group refers to a maximum value of the clear aperture diameters (diameters) in the refractive optical elements in the lens group. Further, the minimum lens diameter of a lens group refers to a minimum value of the clear aperture diameters (diameters) in the refractive optical elements in the lens group.

$$4 < (D1 + D3) / D2 \qquad (2)$$

$$3 < (D3 + D5) / D4 \qquad (3)$$

$$4 < (D5 + D7) / D6 \qquad (4)$$

When than the lower limit values of conditions (2) to (4) are not met, it becomes difficult to obtain a relatively large image side numerical aperture without enlarging the lens diameter while satisfying the Petzval condition. This is not preferable. To further exhibit the effects of the present invention in a satisfactory manner, it is preferred that in condition (2), the lower limit value is set to 4.5 and the upper limit value be set to 8. In the same manner, it is preferred that in condition (3), the lower limit value is set to 3.3 and the upper limit value be set to 8. Further, it is preferred that the lower limit value is set to 4.5 and the upper limit value be set to 10. When these upper limit values are not met, satisfactory correction of the coma aberration or curvature aberration becomes difficult. Thus, this is not preferable.

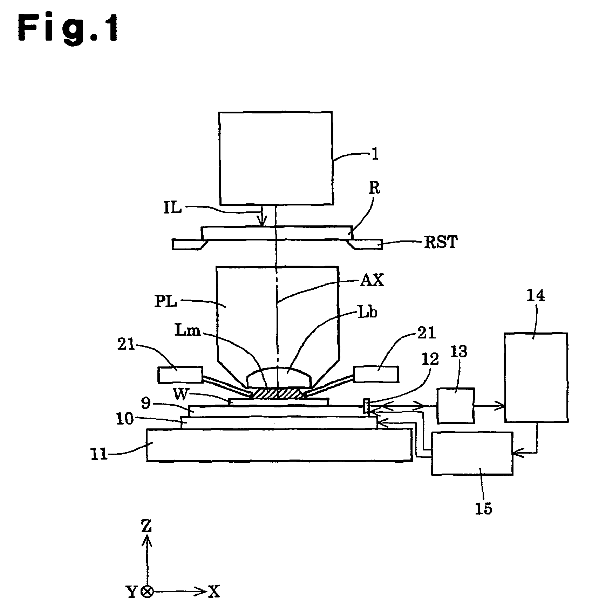

One embodiment of the present invention will now be described with reference to the accompanying drawings. Fig. 1 is a schematic diagram showing the structure of an exposure apparatus according to one embodiment of the present invention. In Fig. 1, the X axis and Y axis are set in directions parallel to a wafer W, and the Z axis is set in a direction orthogonal to the wafer W. More specifically, an XY plane is set parallel to a horizontal plane, and the +Z axis is set to extend upward along a vertical direction.

As shown in Fig. 1, the exposure apparatus of the present embodiment incorporates an illumination optical system 1 including, for example, an ArF excimer laser light source, which is an exposure light source, and formed by an optical integrator (homogenizer), a field stop, a condenser lens, and the like. Exposure light (exposure beam) IL, which is emitted from the light source and includes ultraviolet pulse light having a wavelength of 193 nm, passes through the illumination optical system 1 to illuminate a reticle (mask) R.

A pattern that is to be transferred is formed on the reticle R. In the entire pattern region, a rectangular (slit-shaped) pattern region having a long side extending along the X direction and a short side extending along the Y direction is illuminated. The light passing through the reticle R forms a reticle pattern with a predetermined reduction projection magnification on the exposure region of a wafer (photosensitive substrate) W, which is coated by a photoresist, via a liquid immersion type dioptric projection optical system PL. That is, a pattern image is formed on the wafer W in a rectangular static exposure region (effective exposure region) having a long side extending along the X direction and a short side extending along the Y direction in optical correspondence with the rectangular illumination region on the reticle R.

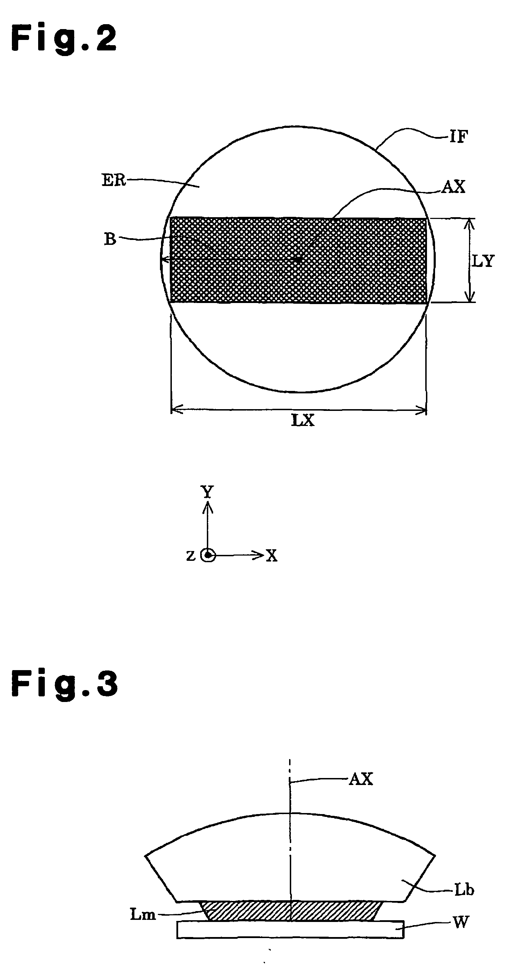

Fig. 2 is a diagram showing the positional relationship of the rectangular static exposure region (i.e., effective exposure region) formed on a wafer relative to an optical axis in the present embodiment. In the present embodiment, referring to Fig. 2, a rectangular static exposure region ER is set about an optical axis AX in a circular region (image circle) IF having a radius B and a center coinciding with the optical axis AX. The length in the X direction of the effective exposure region ER is LX, and the length in the Y direction is LY. Therefore, although not shown in the drawings, a rectangular illumination region having a size and a shape corresponding to the effective exposure region ER is formed on the reticle R.

The reticle R is held parallel to the XY plane on a reticle stage RST, and a mechanism for finely moving the reticle R in the X direction, the Y direction, and a rotation direction is incorporated in the reticle stage RST. A reticle laser interferometer (not shown) measures and controls in real time the position of the reticle stage RST in the X direction, the Y direction, and the rotation direction. The wafer W is fixed parallel to the XY plane on a Z stage 9 by a wafer holder (not shown).

The Z stage 9, which is fixed on an XY stage 10 that moves along the XY plane substantially parallel to an image plane of the projection optical system PL, controls a focus position (position in Z direction) and inclination angle of the wafer W. A wafer laser interferometer 13, which uses a movable mirror 12 arranged on the Z stage 9, measures and controls in real time the position of the Z stage 9 in the X direction, the Y direction, and the rotation direction.

The XY stage 10 is mounted on a base 11 and controls the position of the wafer W in the X direction, the Y direction, and the rotation direction. A main control system 14 arranged in the exposure apparatus of the present embodiment adjusts the position of the reticle R in the X direction, the Y direction, and the rotation direction based on the measurement of a reticle laser interferometer. In other words, the main control system 14 transmits a control signal to a mechanism incorporated in the reticle stage RST and adjusts the position of the reticle R by finely moving the reticle stage RST.

The main control system 14 also adjusts the focus position (position in Z direction) and the inclination angle of the wafer W to align the surface of the wafer W with the image plane of the projection optical system PL by using an automatic focusing technique and an automatic leveling technique. That is, the main control system 14 transmits a control signal to a wafer stage drive system 15 and adjusts the focus position and the inclination angle of the wafer W by driving the Z stage 9 with the wafer stage drive system 15.

Furthermore, the main control system 14 adjusts the position of the wafer W in the X direction, the Y direction, and the rotation direction based on a measurement of the wafer laser interferometer 13. In other words, the main control system 14 transmits a control signal to the wafer stage drive system 15 and performs position adjustment in the X direction, the Y direction, and the rotation direction of the wafer W by driving the XY stage 10 with the wafer stage drive system 15.

During exposure, the main control system 14 transmits a control signal to the mechanism incorporated in the reticle stage RST and also transmits a control signal to the wafer stage drive system 15 to project and expose the pattern image of the reticle R in a predetermined shot region of the wafer W while driving the reticle stage RST and the XY stage 10 at a speed ratio corresponding to the projection magnification of the projection optical system PL. Thereafter, the main control system 14 transmits a control signal to the wafer stage drive system 15 and drives the XY stage 10 with the wafer stage drive system 15 to step-move another shot region on the wafer W to the exposure position.

In this manner, step-and-scan is performed to repeat the operation for scanning and exposing the pattern image of the reticle R onto the wafer W. In the present embodiment, while controlling the positions of the reticle R and the wafer W using the wafer stage drive system 15, the wafer laser interferometer 13, the reticle stage RST and the XY stage 10, and ultimately, the reticle R and the wafer W, are synchronously moved (scanned) along the short side direction, that is, the Y direction, of the rectangular static exposure region and the static illumination region. This scans and exposes the reticle pattern to a region on the wafer W having a width equal to the long side LX of the static exposure region and a length corresponding to the scanning amount (movement amount) of the wafer W

Fig. 3 is a schematic diagram showing the structure between a boundary lens and a wafer in the present embodiment. In the projection optical system PL of the present embodiment, an optical path between the boundary lens Lb and the wafer W is filled with liquid Lm, as shown in Fig. 3. In the present embodiment, pure water (deionized water), which is easy to procure in mass amounts in a semiconductor fabrication plant or the like, is used as the liquid Lm. It is to be noted that water to which $H^+$, $Cs^+$, $K^+$, $Cl^-$, $SO_4^{2-}$, or $PO_4^{2-}$ is added, isopropanol, glycerol, hexane, heptane, decane or the like may be used as the liquid Lm.

In a step-and-scan exposure apparatus that performs scanning exposure while moving the wafer W relative to the projection optical system PL, to continuously fill the optical path between the boundary lens Lb of the projection optical system PL and wafer W from when the scanning exposure is started to when it is finished, the technique described in, for example, International Patent Publication Pamphlet No. WO99/49504 or Japanese Laid-Open Patent Publication No. 10-303114 may be used.

In the technique described in International Patent Publication Pamphlet No. WO99/49504, a liquid supply device supplies and fills the optical path between the boundary lens Lb and the wafer W with liquid adjusted to a predetermined temperature through a supply pipe and a discharge nozzle. Further, the liquid supply device recovers the liquid from the wafer W through a recovery pipe and an intake nozzle. In the technique described in Japanese Laid-Open Patent Publication No. 10-303114, a wafer holder table is formed to have the shape of a container so that is can contain liquid. A wafer is positioned and held through vacuum suction at the center of the inner bottom part of the wafer holder table (in a liquid). Further, the distal portion of the projection optical system PL extends into the liquid, and an optical surface at the wafer side of the boundary lens Lb extends into the liquid.

In the present embodiment, as shown in Fig. 1, the first liquid Lm is circulated in the optical path between the boundary lens Lb and the wafer W using a water supply/discharge mechanism 21. In this manner, such a small flow rate circulation of liquid Lm serving as immersion liquid prevents corrosion and the generation of mold thereby preventing decomposition of the liquid. Further, aberration fluctuations caused by heat absorption of the exposure light can also be prevented.

In the present embodiment, an aspherical surface is expressed by the following equation (a), where y represents the height in a direction perpendicular to the optical axis, z represents the distance (sag amount) along the optical axis from a tangent plane at a vertex of the aspherical surface to a position on the aspherical surface at height y, r represents a vertex curvature radius, K represents a conical coefficient, and $C_n$ represents an n order aspherical surface coefficient. In table (1), which will be described later, an asterisk mark (*) is added to the right side of a surface number for a lens surface having an aspherical shape.

$$z = (y^2/r) / [1 + \{1 - (1 + \kappa) \cdot y^2/r^2\}^{1/2}] + C_4 \cdot y^4 + C_6 \cdot y^6$$
$$+ C_8 \cdot y^8 + C_{10} \cdot y^{10} + C_{12} \cdot y^{12} + C_{14} \cdot y^{14} + C_{16} \cdot y^{16} \qquad (a)$$

[First Example]

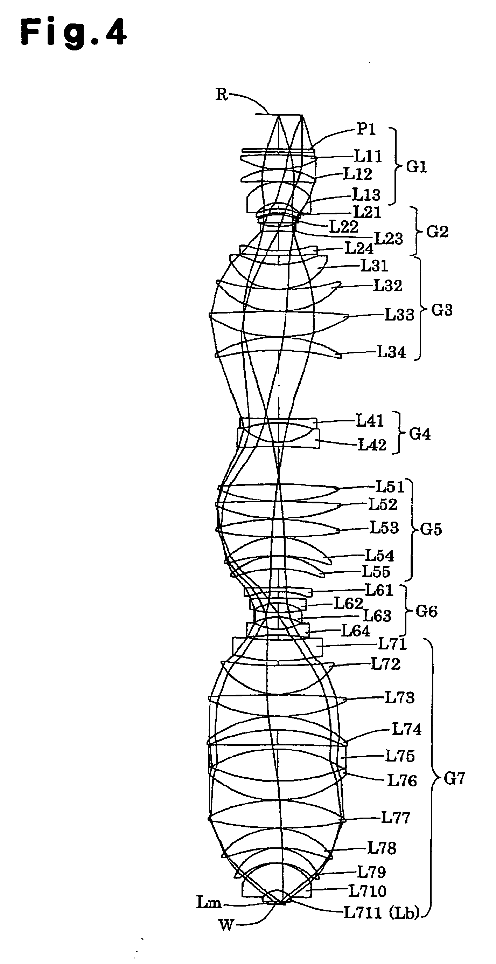

Fig. 4 is a diagram showing a lens structure of a projection optical system according to a first example of the present embodiment. Referring to Fig. 4, the projection optical system PL of the first example includes, sequentially from the reticle side, a first lens group G1 having positive refractive power, a second lens group G2 having negative refractive power, a third lens group G3 having positive refractive power, a fourth lens group G4 having negative refractive power, a fifth lens group G5 having positive refractive power, a sixth lens group G6 having negative refractive power, and a seventh lens group G7 having positive refractive power. The seven-group structure and the refractive power layout are the same in second and third examples, which will be described later.

The first lens group G1 includes, sequentially from the reticle side, a plane-parallel plate P1, a biconvex lens L11, a positive meniscus lens L12 having a convex surface facing toward the reticle side, a negative meniscus lens L13 having a convex surface facing toward the reticle side. The second lens group G2, includes, sequentially from the reticle side, a negative meniscus lens L21 having a convex surface facing toward the reticle side, a positive meniscus lens L22 having an aspherical convex surface facing toward the reticle side, a biconcave lens L23, and a negative meniscus lens L24 having a concave surface facing toward the reticle side.

The third lens group G3 includes, sequentially from the reticle side, a positive meniscus lens L31 having an aspherical concave surface facing toward the reticle side, a positive meniscus lens L32 having a concave surface facing toward the reticle side, a biconvex lens L33, and a positive meniscus lens L34 having a convex surface facing toward the reticle side. The fourth lens group G4 includes, sequentially from the reticle side, a biconcave lens L41 having an aspherical concave surface facing toward the wafer side and a biconcave lens L42.

The fifth lens group G5 includes, sequentially from the reticle side, a biconvex lens L51 having an aspherical convex surface facing toward the reticle side, a biconvex lens L52, a biconvex lens L53, a positive meniscus lens L54 having a convex surface facing toward the reticle side, and a positive meniscus lens L55 having a convex surface facing toward the reticle side. The sixth lens group G6 includes, sequentially from the reticle side, a negative meniscus lens L61 having a convex surface facing toward the reticle side, a negative meniscus lens L62 having an aspherical convex surface facing toward the reticle side, a biconcave lens L63 having an aspherical concave surface facing toward the wafer side, and a biconcave lens L64 having an aspherical concave surface facing toward the wafer side.

The seventh lens group G7 includes, sequentially from the reticle side, a meniscus lens L71 having an aspherical convex surface facing toward the wafer side, a positive meniscus lens L72 having a concave surface facing toward the reticle side, a biconvex lens L73, a positive meniscus lens L74 having a convex surface facing toward the reticle side, a negative meniscus lens L75 having a convex surface facing toward the reticle side, a positive meniscus lens L76 having a concave surface facing toward the reticle side, a biconvex lens L77, a positive meniscus lens L78 having an aspherical concave surface facing toward the wafer side, a positive meniscus lens L79 having an aspherical concave surface facing toward the wafer side, a meniscus lens L710 having a convex surface facing toward the reticle side, and a planoconvex lens L711 (boundary lens) having a planar surface facing toward the wafer side. The position of an aperture stop AS is not shown in Fig. 4. The aperture stop AS may be arranged in an optical path between the negative meniscus lens L75 and the positive meniscus lens L76, i.e., a paraxial pupil position. The aperture stop AS may be arranged at one or more locations separated from the paraxial pupil position in the optical axis direction, for example, at a location between the biconvex lens L77 and the positive meniscus lens L78 and/or at a location in the positive meniscus lens L78.

In the first example, the pure water (Lm) having a refractive index of 1.435876 for the ArF excimer laser light (wavelength λ=193.306nm), which is the light used (exposure light), fills the optical path between the boundary lens Lb and the wafer W. All light transmissive members (P1, L11 to L711 (Lb)) are made of silica ($SiO_2$) having a refractive index of 1.5603261 for the light used. The projection optical system PL is formed to be substantially telecentric to both of the object side and the image side.

In the first example, a conjugation point that is optically conjugated to a point on an optical axis of a pattern surface (object plane) on a reticle R is separated by 17.659 mm from a point on an exit surface of the positive meniscus lens L55 toward the wafer side in the optical axis, that is, located in the optical path between the fifth lens group G5 and the sixth lens group G6. Accordingly, a first imaging system, which is defined as an optical system extending from the reticle R to the conjugation point, is formed by the first to fifth lens groups G1 to G5. A second imaging system, which is defined as an optical system extending from the conjugation point to the wafer W, is formed by the sixth and seventh lens groups G6 and G7.

Values for the data of the projection optical system PL in the first example are shown in table (1). In table (1), λ represents the central wavelength of the exposure light, β represents the magnitude of projection magnification, NA represents the image side (wafer side) numerical aperture, B represents the radius (maximum image height) of the image circle IF on the wafer W, LX represents the X direction dimension (dimension of long side) of the static exposure region ER, and LY represents the Y direction dimension (dimension of short side) of the static exposure region ER. Furthermore, the surface number represents the order of a surface from the reticle side, r represent the curvature radius of each surface (for an aspherical surface, vertex curvature radius: mm), d represents the on-axial interval of each surface, or the surface interval (mm), Φ represents the clear aperture diameter of each surface (diameter: mm), and n represents the refractive index for the central wavelength. The notations in table (1) are the same in following tables (2) and (3).

Table (1)

(Main Data)

λ=193.306nm

β=1/4

NA=1.2

B=13.7mm

LX=26mm

LY=8.8mm

(Optical Member Data)

| Surface No. | r | d | φ | n | Optical member |
|---|---|---|---|---|---|
| | (reticle surface) | 86.37572 | | | |
| 1 | ∞ | 8.00000 | 163.9 | 1. 5603261 | (P1) |
| 2 | ∞ | 6.00000 | 167.1 | | |
| 3 | 1519.64132 | 34.97748 | 172.4 | 1.5603261 | (L11) |
| 4 | -182.80837 | 1.00000 | 175.8 | | |
| 5 | 182.72604 | 30.45810 | 173.3 | 1.5603261 | (L12) |
| 6 | 2574.00309 | 1.00000 | 169.2 | | |
| 7 | 95.57787 | 50.96682 | 147.9 | 1.5603261 | (L13) |
| 8 | 63.07188 | 14.73903 | 100.7 | | |
| 9 | 116.31334 | 11.00000 | 100.1 | 1.5603261 | (L21) |
| 10 | 99.02664 | 4.98043 | 92.5 | | |
| 11* | 130.31812 | 18.84643 | 90.8 | 1.5603261 | (L22) |
| 12 | 949.23006 | 9.90330 | 84.1 | | |
| 13 | -124.80286 | 11.00000 | 81.9 | 1.5603261 | (L23) |
| 14 | 369.40853 | 50.50921 | 82.4 | | |
| 15 | -209.98230 | 11.87260 | 148.8 | 1.5603261 | (L24) |
| 16 | -953.37243 | 23.07738 | 179.0 | | |
| 17* | -176.77870 | 62.68755 | 189.2 | 1.5603261 | (L31) |

(continued)

| No. | r | d | φ | n | Optical member |
|---|---|---|---|---|---|
| 18 | -128.94780 | 1.00000 | 226.1 | | |
| 19 | -458.18364 | 55.40033 | 283.4 | 1.5603261 | (L32) |
| 20 | -192.77762 | 1.00000 | 293.7 | | |
| 21 | 2622.98588 | 63.37825 | 327.6 | 1.5603261 | (L33) |
| 22 | -306.19920 | 1.00000 | 330.0 | | |
| 23 | 282.39378 | 34.04905 | 297.7 | 1.5603261 | (L34) |
| 24 | 586.29235 | 173.47109 | 291.2 | | |
| 25 | -2113.36467 | 11.00000 | 179.2 | 1.5603261 | (L41) |
| 26* | 261.31699 | 48.66658 | 168.4 | | |
| 27 | -119.29791 | 11.00000 | 168.0 | 1.5603261 | (L42) |
| 28 | 1623.56367 | 97.92363 | 191.6 | | |
| 29* | 1785.49110 | 43.35567 | 280.2 | 1.5603261 | (L51) |
| 30 | -375.84595 | 1.00000 | 285.0 | | |
| 31 | 3042.60642 | 43.53217 | 294.9 | 1.5603261 | (L52) |
| 32 | -381.57066 | 3.00000 | 296.5 | | |
| 33 | 502.84736 | 44.29020 | 292.8 | 1.5603261 | (L53) |
| 34 | -847.47644 | 1.00000 | 290.2 | | |
| 35 | 169.30114 | 46.59248 | 253.5 | 1.5603261 | (L54) |
| 36 | 374.65674 | 1.00000 | 244.2 | | |
| 37 | 161.40381 | 32.03253 | 219.0 | 1.5603261 | (L55) |
| 38 | 264.80516 | 47.69004 | 205.8 | | |
| 39 | 1815.25935 | 11.00000 | 158.5 | 1.5603261 | (L61) |
| 40 | 200.94754 | 17.59255 | 138.2 | | |
| 41* | 1093.36220 | 11.00000 | 130.9 | 1.5603261 | (L62) |
| 42 | 89.85032 | 26.13036 | 110.6 | | |
| 43 | -252.47632 | 11.00000 | 110.3 | 1.5603261 | (L63) |
| 44* | 130.80291 | 31.01003 | 109.6 | | |
| 45 | -102.19072 | 14.89174 | 110.4 | 1.5603261 | (L64) |
| 46* | 384.34930 | 11.81854 | 147.2 | | |
| 47 | -528.60745 | 53.98825 | 149.8 | 1.5603261 | (L71) |
| 48* | -250.15948 | 11.03792 | 212.2 | | |
| 49 | -979.45146 | 72.10746 | 254.4 | 1.5603261 | (L72) |
| 50 | -163.21972 | 1.00000 | 268.1 | | |
| 51 | 2026.53017 | 56.01526 | 325.9 | 1.5603261 | (L73) |
| 52 | -364.34648 | 1.00000 | 329.8 | | |
| 53 | 260.64830 | 33.79148 | 336.1 | 1.5603261 | (L74) |
| 54 | 366.75331 | 38.44664 | 330.0 | | |
| 55 | 7696.70128 | 11.00000 | 329.8 | 1.5603261 | (L75) |
| 56 | 295.26482 | 80.48221 | 319.0 | | |
| 57 | ∞ | 0.00000 | | | (AS) |
| 58 | -419.07779 | 47.83984 | 319.9 | 1.5603261 | (L76) |
| 59 | -250.06676 | 1.00000 | 330.0 | | |
| 60 | 347.99334 | 68.81101 | 330.0 | 1.5603261 | (L77) |
| 61 | -781.84384 | 1.00000 | 326.3 | | |
| 62 | 169.07663 | 48.45681 | 265.2 | 1.5603261 | (L78) |
| 63* | 324.83352 | 1.00000 | 253.8 | | |
| 64 | 109.22826 | 36.94196 | 200.1 | 1.5603261 | (L79) |
| 65* | 130.14309 | 1.00000 | 179.4 | | |
| 66 | 94.70193 | 67.34211 | 162.5 | 1.5603261 | (L710) |
| 67 | 41.30448 | 1.00000 | 68.5 | | |

(continued)

| No. | r | d | φ | n | Optical member |
|---|---|---|---|---|---|
| 68 | 39.80829 | 28.51982 | 66.7 | 1.5603261 | (L711:Lb) |
| 69 | ∞ | 5.00001 | 41.5 | 1.435876 | (Lm) |

(wafer surface)

(Aspherical Surface Data)

11th surface: $\kappa=0$
$C_4=3.47122 \times 10^{-7}$     $C_6=7.60095 \times 10^{-12}$
$C_8=2.10180 \times 10^{-14}$     $C_{10}=-1.27489 \times 10^{-17}$
$C_{12}=5.41697 \times 10^{-21}$     $C_{14}=-1.10038 \times 10^{-24}$
$C_{16}=-2.27280 \times 10^{-28}$

17th surface: $\kappa=0$
$C_4=-2.07481 \times 10^{-9}$     $C_6=3.86506 \times 10^{-12}$
$C_8=1.63206 \times 10^{-16}$     $C_{10}=2.07045 \times 10^{-22}$
$C_{12}=1.22025 \times 10^{-24}$     $C_{14}=-2.48877 \times 10^{-28}$
$C_{16}=9.61540 \times 10^{-33}$

26th     surface: $\kappa=0$
$C_4=-1.90528 \times 10^{-8}$     $C_6=2.42165 \times 10^{-13}$
$C_8=7.62252 \times 10^{-19}$     $C_{10}=4.67120 \times 10^{-22}$
$C_{12}=-1.09273 \times 10^{-25}$     $C_{14}=6.77731 \times 10^{-30}$
$C_{16}=0$

29th surface: $\kappa=0$
$C_4=1.04417 \times 10^{-9}$     $C_6=-8.31608 \times 10^{-14}$
$C_8=-4.78966 \times 10^{-19}$     $C_{10}=3.60573 \times 10^{-23}$
$C_{12}=-5.10490 \times 10^{-28}$     $C_{14}=2.29968 \times 10^{-33}$
$C_{16}=0$

41st surface: $\kappa=0$
$C_4=-1.76446 \times 10^{-7}$     $C_6=4.20121 \times 10^{-11}$
$C_8=3.40984 \times 10^{-16}$     $C_{10}=-9.86570 \times 10^{-19}$
$C_{12}=1.47593 \times 10^{-22}$     $C_{14}=-7.63549 \times 10^{-27}$
$C_{16}=0$

44th surface: $\kappa=0$
$C_4=3.01481 \times 10^{-8}$     $C_6=4.91623 \times 10^{-11}$
$C_8=3.50258 \times 10^{-15}$     $C_{10}=-2.88686 \times 10^{-19}$
$C_{12}=4.69414 \times 10^{-23}$     $C_{14}=-3.09140 \times 10^{-26}$
$C_{16}=0$

46th surface: $\kappa=0$
$C_4=-9.57699 \times 10^{-8}$     $C_6=1.42995 \times 10^{-11}$
$C_8=-1.76147 \times 10^{-15}$     $C_{10}=1.48684 \times 10^{-19}$
$C_{12}=-1.36405 \times 10^{-23}$     $C_{14}=5.33426 \times 10^{-28}$
$C_{16}=0$

48th     surface: $\kappa=0$
$C_4=8.06826 \times 10^{-8}$     $C_6=1.04227 \times 10^{-12}$
$C_8=-9.86161 \times 10^{-17}$     $C_{10}=-1.29459 \times 10^{-20}$

(continued)

| No. | r | d | φ | n | Optical member |
|---|---|---|---|---|---|
| $C_{12}$=1. 09429 $\times$ 10$^{-24}$ | | $C_{14}$=-2. 56714 $\times$ 10$^{-29}$ | | | |
| $C_{16}$=0 | | | | | |

63rd surface: κ=0

$C_4$=2. 50898 $\times$ 10$^{-9}$     $C_6$=-5. 56568 $\times$ 10$^{-13}$
$C_8$=3. 72007 $\times$ 10$^{-17}$     $C_{10}$=-1. 14661 $\times$ 10$^{-21}$
$C_{12}$=1. 95642 $\times$ 10$^{-26}$     $C_{14}$=-5. 07636 $\times$     10$^{-32}$
$C_{16}$=0

65th surface: κ=0

$C_4$=1. 36709 $\times$ 10$^{-8}$     $C_6$=3. 57097 $\times$ 10$^{-12}$
$C_8$=-1. 46599 $\times$ 10$^{-16}$     $C_{10}$=1. 53748 $\times$ 10$^{-20}$
$C_{12}$=-4. 37689 $\times$ 10$^{-15}$     $C_{14}$=3. 85487 $\times$     10$^{-29}$
$C_{16}$=0

(Condition Association Values)
$\beta1$=-1. 466
$\beta$=0. 25
D1=175. 8mm (lens L11)
D2=81.9mm (lens L23)
D3=330. 0mm (lens L33)
D4=168. 0mm (lens L42)
D5=296.5mm (lens L52)
D6=109.6mm (lens L63)
D7=336. 1mm (lens L74)
(1) |$\beta1/\beta$|=5. 864
(2) (D1+D3) /D2=6. 18
(3) (D3+D5) /D4=3. 73
(4) (D5+D7)/D6=5. 77

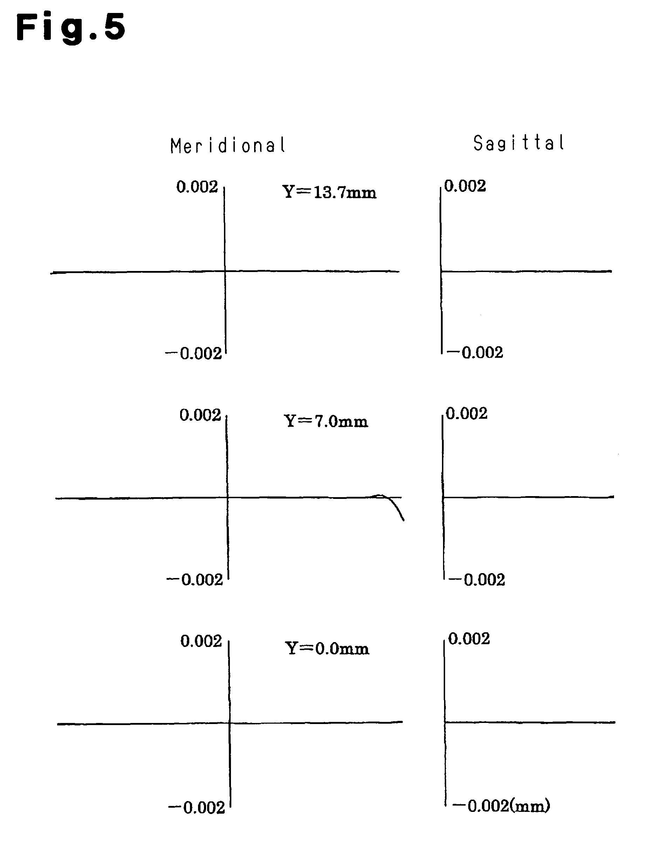

Fig. 5 is a chart showing transverse aberration in the first example. In the aberration chart, Y represents the image height. As apparent from the aberration chart of Fig. 5, in the first example, aberration is corrected in a satisfactory manner for excimer laser light having a wavelength of 193.306 nm even though the image side numerical aperture (NA = 1.3) is extremely large and the static exposure region ER (26 mm $\times$ 8.8 mm) is relatively large.

[Second Example]

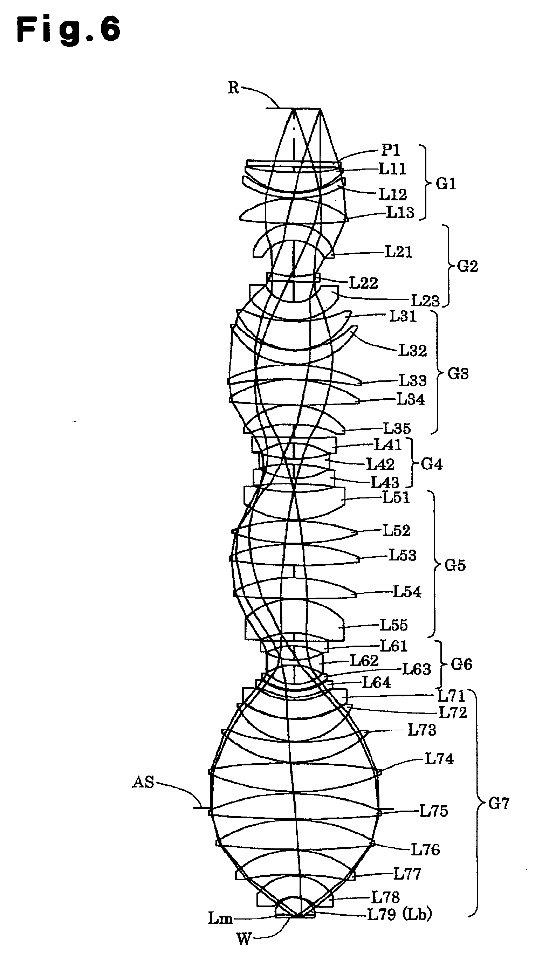

Fig. 6 is a diagram showing a lens structure of a projection optical system according to a second example of the present embodiment. Referring to Fig. 6, in the projection optical system PL of the second example, the first lens group G1 includes, sequentially from the reticle side, a plane-parallel plate P1, a positive meniscus lens L11 having a concave surface facing toward the reticle side, a negative meniscus lens L12 having a concave surface facing toward the reticle side, and a biconvex lens L13. The second lens group G2, includes, sequentially from the reticle side, a negative meniscus lens L21 having a convex surface facing toward the reticle side, a biconcave lens L22 having an aspherical concave surface facing toward the reticle side, and a negative meniscus lens L23 having a concave surface facing toward the reticle side.
The third lens group G3 includes, sequentially from the reticle side, a positive meniscus lens L31 having an aspherical concave surface facing toward the reticle side, a positive meniscus lens L32 having a concave surface facing toward the reticle side, a positive meniscus lens L33 having a convex surface facing toward the reticle side, a biconvex lens L34, and a positive meniscus lens L35 having an aspherical concave surface facing toward the wafer side. The fourth lens group G4 includes, sequentially from the reticle side, a biconcave lens L41 having an aspherical concave surface facing toward the wafer side, a biconcave lens L42, and a biconcave lens L43.
The fifth lens group G5 includes, sequentially from the reticle side, a positive meniscus lens L51 having a concave surface facing toward the reticle side, a biconvex lens L52 having an aspherical convex surface facing toward the reticle side, a biconvex lens L53, a biconvex lens L54, and a positive meniscus lens L55 having a convex surface facing toward the reticle side. The sixth lens group G6 includes, sequentially from the reticle side, a negative meniscus lens L61 having a convex surface facing toward the reticle side, a biconcave lens L62, a negative meniscus lens L63 having a concave surface facing toward the reticle side, and a meniscus lens L64 having an aspherical convex surface facing toward the wafer side.

The seventh lens group G7 includes, sequentially from the reticle side, a meniscus lens L71 having an aspherical convex surface facing toward the wafer side, a positive meniscus lens L72 having a concave surface facing toward the reticle side, a positive meniscus lens L73 having an aspherical concave surface facing toward the reticle side, a biconvex lens L74, a biconvex lens L75, a biconvex lens L76 having an aspherical convex surface facing toward the wafer side, a positive meniscus lens L77 having an aspherical concave surface facing toward the wafer side, a meniscus lens L78 having an aspherical concave surface facing toward the wafer side, and a planoconvex lens L79 (boundary lens Lb) having a planar surface facing toward the wafer side. A paraxial pupil position is located between an entrance side surface and exit side surface of the biconvex lens L75. In the second example, the aperture stop AS is arranged at this paraxial pupil position. Further, in the second example, the aperture stop AS may be arranged at one or more locations separated from the paraxial pupil position in the optical axis direction.

In the same manner as in the first example, in the second example, the pure water (Lm) having a refractive index of 1.435876 for the ArF excimer laser light (wavelength $\lambda$=193.306nm), which is the light used (exposure light), fills the optical path between the boundary lens Lb and the wafer W. All light transmissive members (P1, L11 to L79 (Lb)) are made of silica ($SiO_2$) having a refractive index of 1.5603261 for the light used. The projection optical system PL is formed to be substantially telecentric to both of the object side and the image side.

In the second example, a conjugation point that is optically conjugated to a point on an optical axis of a pattern surface (object plane) on a reticle R is separated by 29.151 mm from a point on an entrance surface of the lens L53 toward the wafer side in the optical path, that is, located in the optical path of the fifth lens group G5. Accordingly, a first imaging system, which is defined as an optical system extending from the reticle R to the conjugation point, is formed by the first lens group G1 to the lens L53 in the fifth lens group G5. A second imaging system, which is defined as an optical system extending from the conjugation point to the wafer W, is formed by the lens L54 in the fifth lens group G5 to the seventh lens groups G7. Values for the data of the projection optical system PL in the second example are shown in table (2).

Table (2)

(Main Data)
$\lambda$=193. 306nm
$\beta$=1/4
NA=1. 25
B=13. 7mm
LX=26mm
LY=8. 8mm

(Optical Member Data)
Surface

| No. | r | d | $\phi$ | n | Optical member |
|---|---|---|---|---|---|
| | (reticle surface) | 114.768369 | | | |
| 1 | ∞ | 12.000000 | 185.1 | 1.5603261 | (P1) |
| 2 | ∞ | 12.000000 | 190.0 | | |
| 3* | -909.09091 | 43.798040 | 191.3 | 1.5603261 | (L11) |
| 4 | -139.37338 | 2.000000 | 199.1 | | |
| 5 | -161.39544 | 12.000000 | 198.9 | 1.5603261 | (L12) |
| 6 | -205.51153 | 1.000000 | 208.1 | | |
| 7 | 180.79377 | 54.610280 | 219.6 | 1.5603261 | (L13) |
| 8 | -1061.01758 | 2.000000 | 214.6 | | |
| 9 | 87.69144 | 35.968171 | 162.9 | 1.5603261 | (L21) |
| 10 | 73.77783 | 80.159216 | 129.6 | | |
| 11* | -149.25373 | 12.000000 | 92.7 | 1.5603261 | (L22) |

(continued)

| No. | r | d | φ | n | Optical member |
|---|---|---|---|---|---|
| 12 | 5637.29229 | 46.154357 | 104.6 | | |
| 13 | -63.81837 | 39.767264 | 115.8 | 1.5603261 | (L23) |
| 14 | -114.07479 | 2.760478 | 180.2 | | |
| 15* | -251.88917 | 62.709847 | 217.7 | 1.5603261 | (L31) |
| 16 | -129.32021 | 1.000000 | 235.1 | | |
| 17 | -165.81829 | 31.151702 | 246.8 | 1.5603261 | (L32) |
| 18 | -150.50791 | 2.000000 | 259.5 | | |
| 19 | 306.76461 | 32.013802 | 276.1 | 1.5603261 | (L33) |
| 20 | 733.53779 | 1.000000 | 273.0 | | |
| 21 | 242.15432 | 56.737165 | 267.7 | 1.5603261 | (L34) |
| 22 | -1908.38792 | 1.000000 | 261.0 | | |
| 23 | 134.29287 | 43.063264 | 206.5 | 1.5603261 | (L35) |
| 24* | 257.73196 | 30.997011 | 183.9 | | |
| 25 | -2113.36467 | 12.000000 | 172.0 | 1.5603261 | (L41) |
| 26* | 124.22360 | 35.867661 | 143.7 | | |
| 27 | -216.35647 | 12.000000 | 142.7 | 1.5603261 | (L42) |
| 28 | 261.06205 | 31.778720 | 141.1 | | |
| 29 | -134.77509 | 12.000000 | 141.6 | 1.5603261 | (L43) |
| 30 | 590.47790 | 18.825011 | 164.5 | | |
| 31 | -314.65541 | 61.903502 | 166.9 | 1.5603261 | (L51) |
| 32 | -177.54743 | 2.000000 | 207.6 | | |
| 33* | 359.71223 | 50.664226 | 255.7 | 1.5603261 | (L52) |
| 34 | -412.99179 | 2.000000 | 258.1 | | |
| 35 | 352.29893 | 47.086214 | 268.9 | 1.5603261 | (L53) |
| 36 | -1073.77854 | 28.486939 | 268.3 | | |
| 37 | 273.66031 | 46.841809 | 253.2 | 1.5603261 | (L54) |
| 38 | -2016.15541 | 1.999999 | 247.2 | | |
| 39 | 143.40892 | 75.752627 | 203.0 | 1.5603261 | (L55) |
| 40 | 164.35704 | 17.144524 | 140.7 | | |
| 41 | 3506.52453 | 12.000000 | 137.8 | 1.5603261 | (L61) |
| 42 | 117.49512 | 31.582866 | 115.6 | | |
| 43 | -120.77089 | 12.000000 | 114.3 | 1.5603261 | (L62) |
| 44 | 105.39922 | 42.071045 | 114.7 | | |
| 45 | -85.08700 | 12.000000 | 116.6 | 1.5603261 | (L63) |
| 46 | -111.59708 | 3.746835 | 133.1 | | |
| 47 | -108.28912 | 12.000000 | 135.4 | 1.5603261 | (L64) |
| 48* | -128.36970 | 7.832515 | 157.4 | | |
| 49 | -136.94881 | 40.840307 | 159.4 | 1.5603261 | (L71) |
| 50* | -161.03060 | 1.000000 | 215.7 | | |
| 51 | -189.25048 | 48.555133 | 217.7 | 1.5603261 | (L72) |
| 52 | -136.02966 | 2.000000 | 238.9 | | |
| 53* | -500.00000 | 44.605292 | 289.8 | 1.5603261 | (L73) |
| 54 | -219.91457 | 2.000000 | 302.7 | | |
| 55 | 1188.08068 | 63.827341 | 356.2 | 1.5603261 | (L74) |
| 56 | -441.07504 | 37.000000 | 360.0 | | |
| 57 | ∞ | -33.000000 | | | (AS) |
| 58 | 462.89791 | 56.700056 | 360.0 | 1.5603261 | (L75) |
| 59 | -1924.49927 | 2.000000 | 356.4 | | |
| 60 | 329.27200 | 65.563684 | 330.8 | 1.5603261 | (L76) |
| 61* | -1315.78947 | 2.000000 | 322.9 | | |

(continued)

| No. | r | d | φ | n | Optical member |
|---|---|---|---|---|---|
| 62 | 192.94396 | 53.553678 | 249.3 | 1.5603261 | (L77) |
| 63* | 751.87970 | 2.000000 | 221.9 | | |
| 64 | 99.20631 | 45.000000 | 156.4 | 1.5603261 | (L78) |
| 65* | 54.76451 | 2.000000 | 90.2 | | |
| 66 | 46.93959 | 37.111052 | 80.9 | 1.5603261 | (L79:Lb) |
| 67 | ∞ | 5.000000 | 43.6 | 1.435876 | (Lm) |
| | (wafer surface) | | | | |

(Aspherical Surface Data)

3rd surface: $\kappa=0$

$C_4=-6.00201 \times 10^{-8}$ $\qquad$ $C_6=2.36809 \times 10^{-13}$

$C_8=-2.22188 \times 10^{-17}$ $\qquad$ $C_{10}=-1.56383 \times 10^{-22}$

$C_{12}=0$, $C_{14}=0$, $C_{16}=0$

11th surface: $\kappa=0$

$C_4=2.19161 \times 10^{-8}$ $\qquad$ $C_6=3.00989 \times 10^{-12}$

$C_8=4.12041 \times 10^{-16}$ $\qquad$ $C_{10}=-1.11896 \times 10^{-19}$

$C_{12}=1.45715 \times 10^{-23}$ $\qquad$ $C_{14}=1.34291 \times 10^{-26}$

$C_{16}=0$

15th surface: $\kappa=0$

$C_4=3.92779 \times 10^{-8}$ $\qquad$ $C_6=-4.86986 \times 10^{-12}$

$C_8=1.35399 \times 10^{-16}$ $\qquad$ $C_{10}=6.05322 \times 10^{-22}$

$C_{12}=-8.91463 \times 10^{-26}$ $\qquad$ $C_{14}=5.47521 \times 10^{-31}$

$C_{16}=4.30586 \times 10^{-35}$

24th surface: $\kappa=0$

$C_4=8.52139 \times 10^{-8}$ $\qquad$ $C_6=-2.83738 \times 10^{-12}$

$C_8=2.26382 \times 10^{-16}$ $\qquad$ $C_{10}=-2.26602 \times 10^{-20}$

$C_{12}=1.29968 \times 10^{-24}$ $\qquad$ $C_{14}=-1.03621 \times 10^{-28}$

$C_{16}=0$

26th surface: $\kappa=0$

$C_4=-4.86877 \times 10^{-8}$ $\qquad$ $C_6=3.96291 \times 10^{-12}$

$C_8=-8.80679 \times 10^{-16}$ $\qquad$ $C_{10}=9.60530 \times 10^{-20}$

$C_{12}=-7.50546 \times 10^{-24}$ $\qquad$ $C_{14}=8.94838 \times 10^{-28}$

$C_{16}=0$

33rd surface: $\kappa=0$

$C_4=-4.99937 \times 10^{-9}$ $\qquad$ $C_6=-2.62339 \times 10^{-13}$

$C_8=1.31972 \times 10^{-18}$ $\qquad$ $C_{10}=1.21574 \times 10^{-22}$

$C_{12}=-4.76511 \times 10^{-27}$ $\qquad$ $C_{14}=6.75214 \times 10^{-32}$

$C_{16}=0$

48th surface: $\kappa=0$

$C_4=1.21064 \times 10^{-7}$ $\qquad$ $C_6=8.63013 \times 10^{-12}$

$C_8=9.86102 \times 10^{-16}$ $\qquad$ $C_{10}=4.50529 \times 10^{-20}$

$C_{12}=-2.08231 \times 10^{-24}$ $\qquad$ $C_{14}=-6.53239 \times 10^{-28}$

$C_{16}=0$

50th surface: $\kappa=0$

$C_4=5.96114 \times 10^{-8}$ $\qquad$ $C_6=5.46715 \times 10^{-13}$

(continued)

| No. | r | d | φ | n | Optical member |
|---|---|---|---|---|---|

$C_8$=-1. 05124 × 10$^{-16}$   $C_{10}$=-4. 36686 × 10$^{-21}$
$C_{12}$=6. 50858 × 10$^{-25}$   $C_{14}$=-2. 34532 × 10$^{-29}$
$C_{16}$=0

53rd surface: κ=0
$C_4$=-1. 12567 × 10$^{-8}$   $C_6$=-1. 03937 × 10$^{-13}$
$C_8$=-2. 22588 × 10$^{18}$   $C_{10}$=2. 27145 × 10$^{-23}$
$C_{12}$=-1. 12393 × 10$^{-27}$   $C_{14}$=2. 84587 × 10$^{-32}$
$C_{16}$=0

61st surface: κ=0
$C_4$=-3. 39908 × 10$^{-10}$   $C_6$=5. 97624 × 10$^{-14}$
$C_8$=1. 20433 × 10$^{-18}$   $C_{10}$=-6. 06006 × 10$^{-23}$
$C_{12}$=9. 98779 × 10$^{-28}$   $C_{14}$=-6. 46623 × 10$^{-33}$
$C_{16}$=0
63rd surface: κ=0
$C_4$=1. 39006 × 10$^{-8}$   $C_6$=8. 02702 × 10$^{-13}$
$C_8$=-5. 69338 × 10$^{-17}$   $C_{10}$=3. 14626 × 10$^{-21}$
$C_{12}$=-9. 40227 × 10$^{-26}$   $C_{14}$=1. 44247 × 10$^{-30}$
$C_{16}$=0

65th surface: κ=0
$C_4$=-4. 55884 × 10$^{-7}$   $C_6$=-7. 13401 × 10$^{-11}$
$C_8$=1. 07064 × 10$^{-14}$   $C_{10}$=-7. 54707 × 10$^{-18}$
$C_{12}$=1. 58001 × 10$^{-21}$   $C_{14}$=-4. 93383 × 10$^{-25}$
$C_{16}$=0

(Condition Association Values)
$\beta 1$=-2. 090
$\beta$=0. 25
D1=219. 6mm (lens L13)
D2=92.7mm (lens L22)
D3=276. 1mm (lens L33)
D4=141. 1mm (lens L42)
D5=268.9mm (lens L53)
D6=114.3mm (lens L62)
D7=360. 0mm (lens L74, L75)
(1) $|\beta 1/\beta|$=8. 358
(2) (D1+D3) /D2=5. 35
(3) (D3+D5) /D4=3. 86
(4) (D5+D7) /D6=5. 50

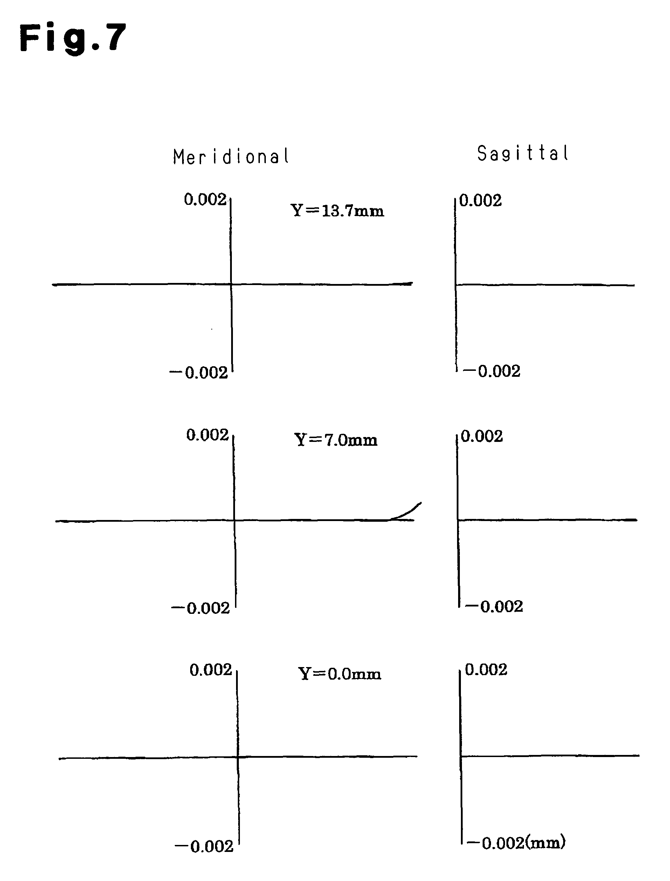

Fig. 7 is a chart showing transverse aberration in the second example. In the aberration chart, Y represents the image height. As apparent from the aberration chart of Fig. 7, in the same manner as in the first example, in the second example, aberration is corrected in a satisfactory manner for excimer laser light having a wavelength of 193.306 nm even though the image side numerical aperture (NA = 1.25) is extremely large and the static exposure region ER (26 mm × 8.8 mm) is relatively large.

[Third Example]

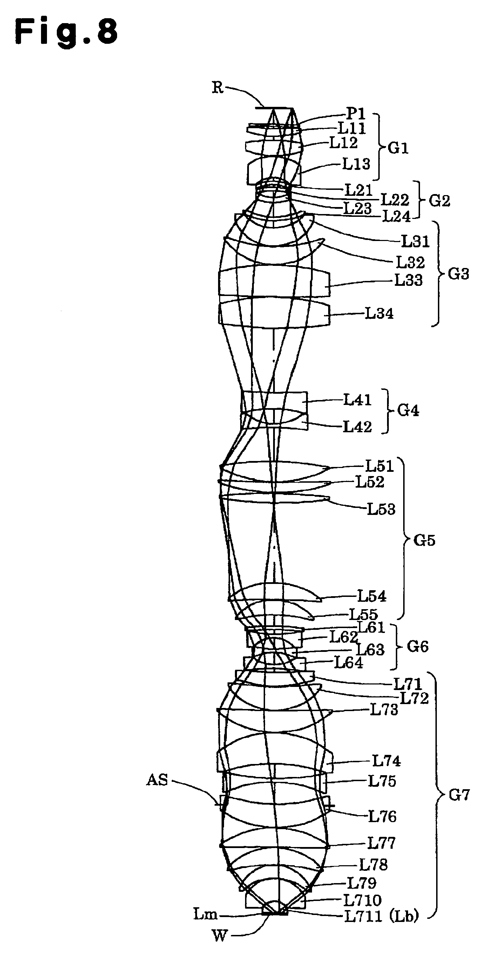

Fig. 8 is a diagram showing a lens structure of a projection optical system according to a third example of the present embodiment. Referring to Fig. 8, in the projection optical system PL of the third example, the first lens group G1 includes, sequentially from the reticle side, a plane-parallel plate P1, a positive meniscus lens L11 having a concave surface facing toward the reticle side, a biconvex lens L12, and a negative meniscus lens L13 having a convex surface facing toward the reticle side. The second lens group G2, includes, sequentially from the reticle side, a negative meniscus lens L21 having a convex surface facing toward the reticle side, a meniscus lens L22 having an aspherical convex surface facing toward the reticle side, a negative meniscus lens L23 having a concave surface facing toward the reticle side, and a negative meniscus lens L24 having a concave surface facing toward the reticle side.

The third lens group G3 includes, sequentially from the reticle side, a positive meniscus lens L31 having an aspherical concave surface facing toward the reticle side, a positive meniscus lens L32 having a concave surface facing toward the reticle side, a biconvex lens L33, and a biconvex lens L34. The fourth lens group G4 includes, sequentially from the reticle side, a biconcave lens L41 having an aspherical concave surface facing toward the wafer side and a biconcave lens L42.

The fifth lens group G5 includes, sequentially from the reticle side, a biconvex lens L51 having an aspherical convex surface facing toward the reticle side, a positive meniscus lens L52 having a concave surface facing toward the reticle side, a biconvex lens L53, a positive meniscus lens L54 having a convex surface facing toward the reticle side, and a positive meniscus lens L55 having a convex surface facing toward the reticle side. The sixth lens group G6 includes, sequentially from the reticle side, a positive meniscus lens L61 having a convex surface facing toward the reticle side, a biconcave lens L62 having an aspherical concave surface facing toward the reticle side, a biconcave lens L63 having an aspherical concave surface facing toward the wafer side, and a biconcave lens L64 having an aspherical concave surface facing toward the wafer side.

The seventh lens group G7 includes, sequentially from the reticle side, a positive meniscus lens L71 having an aspherical convex surface facing toward the wafer side, a positive meniscus lens L72 having a concave surface facing toward the reticle side, a positive meniscus lens L73 having a concave surface facing toward the reticle side, a positive meniscus lens L74 having a convex surface facing toward the reticle side, a biconcave lens L75, a positive meniscus lens L76 having a concave surface facing toward the reticle side, a positive meniscus lens L77 having a convex surface facing toward the reticle side, a positive meniscus lens L78 having an aspherical concave surface facing toward the wafer side, a positive meniscus lens L79 having an aspherical concave surface facing toward the wafer side, a negative meniscus lens L710 having a convex surface facing toward the reticle side, and a planoconvex lens L711 (boundary lens Lb) having a planar surface facing toward the wafer side. In the third example, a paraxial pupil position is located in the positive meniscus lens L76, and the aperture stop AS may be arranged near the paraxial pupil position. Further, the aperture stop AS may be arranged at one or more locations separated from the paraxial pupil position in the optical axis direction.

In the same manner as in the first and second examples, in the third example, the pure water (Lm) having a refractive index of 1.435876 for the ArF excimer laser light (wavelength $\lambda$=193.306nm), which is the light used (exposure light), fills the optical path between the boundary lens Lb and the wafer W. All light transmissive members (P1, L11 to L711 (Lb)) are made of silica ($SiO_2$) having a refractive index of 1.5603261 for the light used. The projection optical system PL is formed to be substantially telecentric to both of the object side and the image side.

In the third example, a conjugation point that is optically conjugated to a point on an optical axis of a pattern surface (object plane) on a reticle R is separated by 143.863 mm from a point on an entrance surface of the lens L53 toward the wafer side in the optical path, that is, located in the optical path between the lens L53 and lens L54 of the fifth lens group G5. Accordingly, a first imaging system, which is defined as an optical system extending from the reticle R to the conjugation point, is formed by the first lens group G1 to the lens L53 in the fifth lens group G5. A second imaging system, which is defined as an optical system extending from the conjugation point to the wafer W, is formed by the lens L54 in the fifth lens group G5 to the seventh lens groups G7. Values for the data of the projection optical system PL in the third example are shown in table (3).

Table (3)

(Main Data)
$\lambda$=193. 306nm
$\beta$=1/4
NA=1. 2
B=14mm
LX=26mm
LY=10. 4mm

(continued)

(Optical Member Data)

| Surface No. | r | d | φ | n | Optical member |
|---|---|---|---|---|---|
|  | (reticle surface) | 51.094891 |  |  |  |
| 1 | ∞ | 8.175182 | 143.7 | 1.5603261 | (P1) |
| 2 | ∞ | 6. 131387 | 146.8 |  |  |
| 3 | -1463.73482 | 24.796927 | 149.4 | 1.5603261 | (L11) |
| 4 | -259.24325 | 13.452150 | 155.7 |  |  |
| 5 | 436.59865 | 50.376986 | 166.2 | 1.5603261 | (L12) |
| 6 | -231.96976 | 1.021898 | 167.8 |  |  |
| 7 | 124.00336 | 67.801652 | 152.2 | 1.5603261 | (L13) |
| 8 | 70.41213 | 12.424410 | 103.7 |  |  |
| 9 | 121.37143 | 11.240876 | 103.6 | 1.5603261 | (L21) |
| 10 | 109.95358 | 7.194166 | 99.2 |  |  |
| 11* | 155.60037 | 11.551309 | 99.0 | 1.5603261 | (L22) |
| 12 | 182.10414 | 22.072039 | 96.5 |  |  |
| 13 | -102.30028 | 16.036540 | 96.2 | 1.5603261 | (L23) |
| 14 | -142.98203 | 47.451515 | 104.7 |  |  |
| 15 | -173.58313 | 11.681685 | 166.8 | 1.5603261 | (L24) |
| 16 | -211.21285 | 22.967573 | 184.3 |  |  |
| 17* | -121.88701 | 60.221524 | 185.5 | 1.5603261 | (L31) |
| 18 | -128.09592 | 1.021898 | 235.9 |  |  |
| 19 | -392.60315 | 58.818133 | 295.2 | 1.5603261 | (L32) |
| 20 | -187.70969 | 1.021898 | 305.0 |  |  |
| 21 | 606.67782 | 102.189781 | 339.6 | 1.5603261 | (L33) |
| 22 | -3496.83097 | 1.021898 | 339.4 |  |  |
| 23 | 594.87474 | 102.189781 | 337.6 | 1.5603261 | (L34) |
| 24 | -1185.58201 | 214.209711 | 321.1 |  |  |
| 25 | -2159.64273 | 53.674028 | 195.9 | 1.5603261 | (L41) |
| 26* | 355.27134 | 49.112705 | 177.7 |  |  |
| 27 | -131.25514 | 11.240876 | 177.6 | 1.5603261 | (L42) |
| 28 | 676.82273 | 111.114483 | 210.0 |  |  |
| 29* | 780.71326 | 67.136173 | 376.1 | 1.5603261 | (L51) |
| 30 | -345.72949 | 1.021898 | 372.6 |  |  |
| 31 | -2844.84158 | 34.580070 | 387.9 | 1.5603261 | (L52) |
| 32 | -509.20848 | 2.043796 | 388.6 |  |  |
| 33 | 1739.83703 | 31.144748 | 385.2 | 1.5603261 | (L53) |
| 34 | -1118.78325 | 265.693431 | 384.7 |  |  |
| 35 | 226.02394 | 54.982019 | 281.9 | 1.5603261 | (L54) |
| 36 | 1942.61661 | 1.021898 | 276.1 |  |  |
| 37 | 155.30114 | 48.885484 | 235.5 | 1.5603261 | (L55) |
| 38 | 402.04803 | 37.482461 | 222.3 |  |  |
| 39 | 735.15490 | 11.240876 | 174.0 | 1.5603261 | (L61) |
| 40 | 788.36653 | 14.842375 | 162.9 |  |  |
| 41* | -310.92400 | 11.240876 | 160.7 | 1.5603261 | (L62) |
| 42 | 79.47793 | 36.825969 | 123.8 |  |  |
| 43 | -343.47986 | 11.240876 | 123.9 | 1.5603261 | (L63) |
| 44* | 134.60961 | 39.852450 | 130.1 |  |  |
| 45 | -110.25461 | 11.240876 | 131.8 | 1.5603261 | (L64) |

(continued)

| No. | r | d | φ | n | Optical member |
|---|---|---|---|---|---|
| 46* | 311.22495 | 12.916879 | 181.6 | | |
| 47 | -908.13971 | 45.318482 | 188.0 | 1.5603261 | (L71) |
| 48* | -259.96849 | 1.834731 | 233.8 | | |
| 49 | -754.45772 | 77.050464 | 259.4 | 1.5603261 | (L72) |
| 50 | -175.95131 | 1.021898 | 282.9 | | |
| 51 | -3103.13791 | 72.654086 | 341.7 | 1.5603261 | (L73) |
| 52 | -265.83679 | 1.021898 | 348.7 | | |
| 53 | 281.70867 | 102.189781 | 347.8 | 1.5603261 | (L74) |
| 54 | 516.39802 | 47.023703 | 312.4 | | |
| 55 | -670.17561 | 11.241419 | 310.2 | 1.5603261 | (L75) |
| 56 | 363.92030 | 73.438554 | 302.8 | | |
| 57 | ∞ | -2.567047 | | | (AS) |
| 58 | -476.06631 | 75.452298 | 307.0 | 1.5603261 | (L76) |
| 59 | -295.97462 | 1.021898 | 330.3 | | |
| 60 | 293.15804 | 62.727023 | 334.0 | 1.5603261 | (L77) |
| 61 | 16539.35648 | 1.021898 | 329.7 | | |
| 62 | 202.58064 | 53.979809 | 298.0 | 1.5603261 | (L78) |
| 63* | 501.39136 | 1.021898 | 289.5 | | |
| 64 | 119.67915 | 41.514916 | 221.3 | 1.5603261 | (L79) |
| 65* | 152.47807 | 1.021898 | 201.0 | | |
| 66 | 103.48438 | 72.499275 | 180.1 | 1.5603261 | (L710) |
| 67 | 46.75184 | 1.021898 | 79.9 | | |
| 68 | 42.95688 | 36.630648 | 76.3 | 1.5603261 | L711:Lb) |
| 69 | ∞ | 6.338758 | 43.1 | 1.435876 | (Lm) |

(wafer surface)

(Aspherical Surface Data)

11th surface: $\kappa=0$

$C_4=1.37393 \times 10^{-8}$    $C_6=-7.78559 \times 10^{-12}$

$C_8=1.98875 \times 10^{-15}$    $C_{10}=-7.94757 \times 10^{-18}$

$C_{12}=3.96286 \times 10^{-21}$    $C_{14}=-1.06425 \times 10^{-24}$

$C_{16}=1.03200 \times 10^{-28}$

17th surface: $\kappa=0$

$C_4=-2.59194 \times 10^{-8}$    $C_6=8.66157 \times 10^{-13}$

$C_8=1.37970 \times 10^{-17}$    $C_{10}=5.93627 \times 10^{-21}$

$C_{12}=6.85375 \times 10^{-25}$    $C_{14}=-2.90262 \times 10^{-29}$

$C_{16}=6.11666 \times 10^{-33}$

26th surface: $\kappa=0$

$C_4=1.44892 \times 10^{-8}$    $C_6=4.21963 \times 10^{-13}$

$C_8=2.05550 \times 10^{-17}$    $C_{10}=-7.36804 \times 10^{-22}$

$C_{12}=1.54488 \times 10^{-25}$    $C_{14}=-2.87728 \times 10^{-30}$

$C_{16}=0$

29th surface: $\kappa=0$

$C_4=-3.55466 \times 10^{-9}$    $C_6=-2.75444 \times 10^{-14}$

$C_8=7.98107 \times 10^{-19}$    $C_{10}=-1.12178 \times 10^{-23}$

$C_{12}=1.02335 \times 10^{-28}$    $C_{14}=-4.83517 \times 10^{-34}$

$C_{16}=0$

(continued)

| No. | r | d | φ | n | Optical member |
|---|---|---|---|---|---|

41st surface: $\kappa=0$
$C_4=-3.96417 \times 10^{-8}$  $C_6=2.38949 \times 10^{-11}$
$C_8=-3.60945 \times 10^{-15}$  $C_{10}=3.38133 \times 10^{-19}$
$C_{12}=-1.95214 \times 10^{-23}$  $C_{14}=5.34141 \times 10^{-28}$
$C_{16}=0$

44th surface: $\kappa=0$
$C_4=-3.86838 \times 10^{-8}$  $C_6=1.52228 \times 10^{-11}$
$C_8=-2.61526 \times 10^{-15}$  $C_{10}=1.58228 \times 10^{-19}$
$C_{12}=-2.06992 \times 10^{-23}$  $C_{14}=-9.75169 \times 10^{-28}$
$C_{16}=0$

46th surface: $\kappa=0$
$C_4=-1.68578 \times 10^{-7}$  $C_6=1.16791 \times 10^{-11}$
$C_8=-7.98020 \times 10^{-16}$  $C_{10}=4.50628 \times 10^{-20}$
$C_{12}=-1.93836 \times 10^{-24}$  $C_{14}=3.72188 \times 10^{-29}$
$C_{16}=0$

48th surface: $\kappa=0$
$C_4=4.18393 \times 10^{-8}$  $C_6=8.93158 \times 10^{-13}$
$C_8=-3.08968 \times 10^{-17}$  $C_{10}=-5.18125 \times 10^{-21}$
$C_{12}=2.79972 \times 10^{-25}$  $C_{14}=-4.07427 \times 10^{-30}$
$C_{16}=0$

63rd surface: $\kappa=0$
$C_4=-2.46119 \times 10^{-9}$  $C_6=-4.80943 \times 10^{-13}$
$C_8=4.23462 \times 10^{-17}$  $C_{10}=-1.44192 \times 10^{-21}$
$C_{12}=2.64358 \times 10^{-26}$  $C_{14}=-2.03060 \times 10^{-31}$
$C_{16}=0$

65th surface: $\kappa=0$
$C_4=7.65330 \times 10^{-9}$  $C_6=4.60588 \times 10^{-12}$
$C_8=-2.33473 \times 10^{-16}$  $C_{10}=1.90470 \times 10^{-20}$
$C_{12}=-6.40667 \times 10^{-25}$  $C_{14}=2.75306 \times 10^{-29}$
$C_{16}=0$

(Condition Association Values)
$\beta 1=-2.477$
$\beta=0.25$
D1=167.8mm (lens L12)
D2=96.2mm (lens L23)
D3=339.6mm (lens L33)
D4=177.6mm (lens L42)
D5=388.6mm (lens L52)
D6=123.8mm (lens L62)
D7=348.7mm (lens L73)
(1) $|\beta 1/\beta|=9.909$
(2) (D1+D3)/D2=5.27
(3) (D3+D5)/D4=4.10
(4) (D5+D7)/D6=5.96

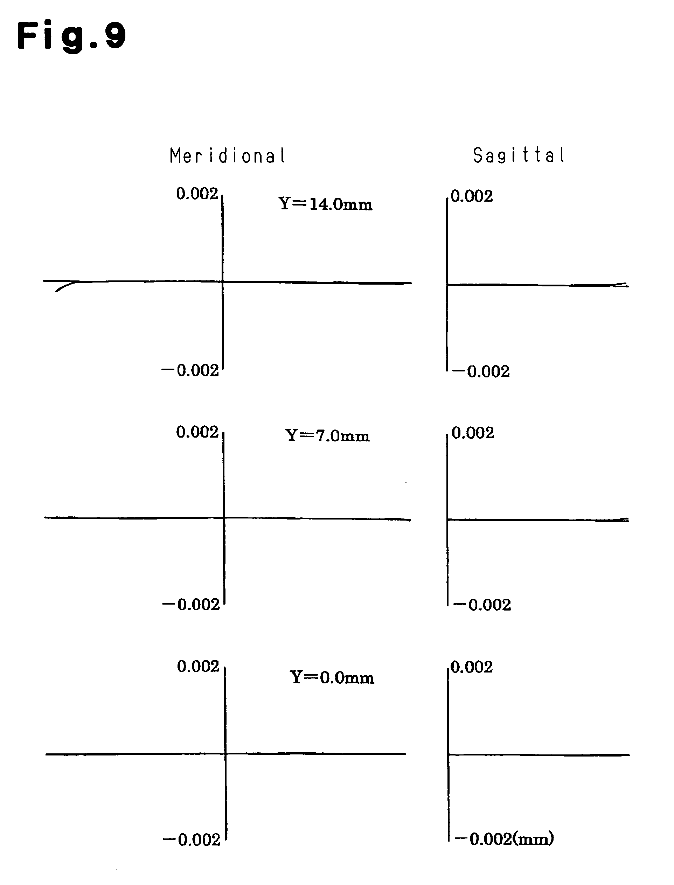

Fig. 9 is a chart showing transverse aberration in the third example. In the aberration chart, Y represents the image height. As apparent from the aberration chart of Fig. 7, in the same manner as in the first example and the second example, in the third example, aberration is corrected in a satisfactory manner for excimer laser light having a wavelength of 193.306 nm even though the image side numerical aperture (NA = 1.2) is extremely large and the static exposure region ER (26 mm × 10.4 mm) is relatively large.

In this manner, in the projection optical system PL of the present embodiment, the arrangement of the pure water Lm, which has a large refractive index, in the optical path between the boundary lens Lb and the wafer W obtains a relatively large effective imaging field while obtaining a relatively large effective image side numerical aperture. In other words, in each of the examples, a high image side numerical aperture of 1.2 to 1.25 is obtained for the ArF excimer laser light of which central wavelength is 193.306 nm. At the same time, a rectangular static exposure region ER having a rectangular shape of 26 mm × 8.8 mm or 26 mm × 10.4 mm is obtained. Thus, scanning exposure may be performed with high resolution on a circuit pattern in a rectangular exposure region of, for example, 26 mm × 33 mm.

In the above-described first example, the conjugation point optically conjugated to a point on the optical axis of the pattern surface (object plane) of the reticle R is located between the two lens L55 and L61. This clearly defines the first imaging system as an optical system from the reticle R to the conjugation point and the second imaging system as an optical system from the conjugation point to the wafer W. In the second example, the conjugation point optically conjugated to a point on the optical axis of the pattern surface (object plane) of the reticle R is located between the entrance surface and exit surface of the lens L53. This clearly defines the first imaging system as an optical system from the reticle R to the conjugation point and the second imaging system as an optical system from the conjugation point to the wafer W.

In the third example, the conjugation point optically conjugated to a point on the optical axis of the pattern surface (object plane) of the reticle R is located between the two lenses L53 and L54. This clearly defines the first imaging system as an optical system from the reticle R to the conjugation point and the second imaging system as an optical system from the conjugation point to the wafer W. In the present invention, when the conjugation point optically conjugated to a point on the optical axis of the pattern surface (object plane) is located in the optical element (such as lens), when the conjugation point is close (physical length) to the entrance surface of that optical element, the first imaging system is defined extending to the optical element located next to the object side (first surface side) of that optical element. When the conjugation point is close (physical length) to the exit surface of that optical element, the first imaging system is defined extending to that optical element.

In each of the above examples, the present invention is applied to an optical system that includes only one conjugation point optically conjugated to a point on the optical axis of the pattern surface (object plane) of the reticle R. That is, the present invention is applied to a twice-imaging type optical system. However, the present invention is not limited in such a manner and may also be applied to a thrice or more, plural imaging type (thrice-imaging type, four-time-imaging type, and the like) optical system in which a plurality of conjugation points are included in the projection optical system. In other words, the first imaging system and the second imaging system are not limited to an optical system of a once-imaging type and may be a twice or more, plural imaging type imaging system.

In the above-described embodiment, instead of the mask (reticle), a pattern formation device may be used for forming a predetermined pattern based on predetermined electronic data. The employment of such a pattern formation device minimizes the influence a pattern plane has on the synchronizing accuracy even when the pattern plane is arranged perpendicular to the above embodiment. A digital micro-mirror device (DMD), which is driven based on, for example, predetermined electronic data, may be used as the pattern formation device. Exposure apparatuses using DMDs are described, for example, in Japanese Laid-Open Patent Publication No. 8-313842 and Japanese Laid-Open Patent Publication No. 2004-304135. Moreover, in addition to a non-light-emitting reflective type spatial light modulator such as a DMD, a transmissive type spatial light modulator may be used. Alternatively, a light-emitting type image display device may be used.

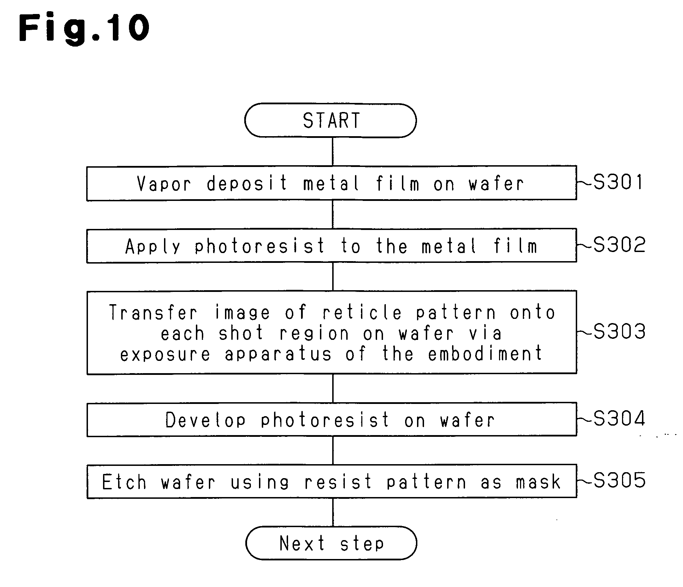

In the exposure apparatus of the above-described embodiment, a micro-device (semiconductor device, imaging device, liquid crystal display device, thin-film magnetic head, and the like) can be manufactured by illuminating a reticle (mask) with an illumination device (illumination process), and exposing a transfer pattern formed on a mask onto a photosensitive substrate using the projection optical system (exposure process). One example of the procedures for obtaining a semiconductor device serving as the micro-device by forming a predetermined circuit pattern on a wafer or the like serving as the photosensitive substrate using the exposure apparatus of the present embodiment will be described below with reference to the flowchart of Fig. 10.

First, in step 301 of Fig. 10, a metal film is vapor-deposited on a single lot of wafers. Next, in step 302, photoresist is applied to the metal film on the single lot of wafers. Then, in step 303, the image of a pattern on a mask (reticle) is sequentially exposed and transferred to each shot region in the single lot of wafers with the projection optical system of the exposure apparatus of the present embodiment. After the photoresist on the single lot of wafers is developed in step 304, etching is carried out on the single lot of wafers using a resist pattern as the mask in step 305 so that a circuit pattern corresponding to the pattern on the mask is formed in each shot region of each wafer.

Subsequently, a device such as semiconductor device is manufactured by forming circuit patterns in upper layers. The semiconductor device manufacturing method described above obtains semiconductor devices having extremely fine circuit patterns with satisfactory throughput. In step 301 to step 305, metal is vapor-deposited on the wafers, resist is applied to the metal film, and the processes of exposure, development, and etching are performed. However, it is obvious that prior to such processes, a silicon oxide film may be formed on the wafers and then resist may be applied o the silicon oxide film and the processes of exposure, development, and etching can be performed.

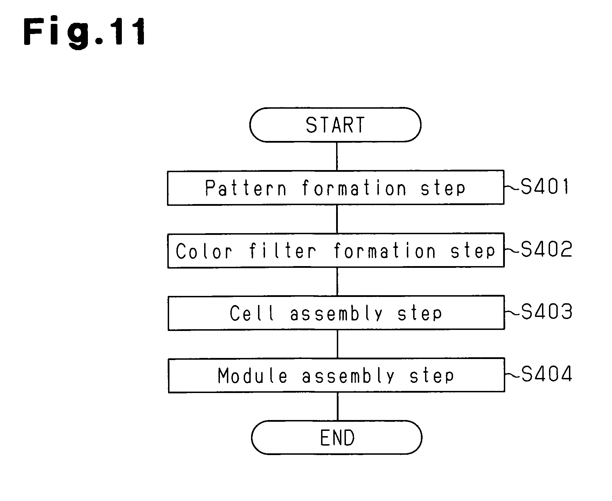

In the exposure apparatus of the present embodiment, a liquid crystal display device serving as a micro-device can be obtained by forming a predetermined pattern (circuit pattern, electrode pattern, or the like) on a plate (glass substrate). One example of the procedures taken in this case will now be described with reference to the flowchart of Fig. 11. In Fig. 11, a so-called photolithography process of transferring and exposing a pattern of a mask onto a photosensitive substrate (glass substrate applied with resist and the like) using the exposure apparatus of the present embodiment is performed in a pattern formation step 401. A predetermined pattern including many electrodes is formed on the photosensitive substrate through the photolithography process. The exposed substrate then undergoes the processes including a development step, an etching step, and a resist removal step to form a predetermined pattern on the substrate. Then, the next color filter formation step 402 is performed.

In the color filter formation step 402, a color filter is formed in which many sets of three dots corresponding to R (Red), G (Green), and B (Blue) are arranged in a matrix form or in which a plurality of sets of three stripe filters of R, G, and B are arranged extending in a horizontal scanning line direction. After the color filter formation step 402, a cell assembling step 403 is performed. In the cell assembling step 403, a liquid crystal panel (liquid crystal cell) is assembled using the substrate having the predetermined pattern obtained in the pattern formation step 401 and the color filter obtained in the color filter formation step 402.

In the cell assembly step 403, a liquid crystal panel (liquid crystal cell) is manufactured by injecting liquid crystal between the substrate having the predetermined pattern obtained in the pattern formation step 401 and the color filter obtained in the color filter formation step 402. Thereafter, in a module assembling step 404, components such as electric circuits and a backlight for enabling a display operation of the assembled liquid crystal panel (liquid crystal cell) are mounted to complete a liquid crystal display device. In the above-described manufacturing method for a liquid crystal display device, liquid crystal display devices having extremely fine circuit patterns are obtained with satisfactory throughput.

An ArF excimer laser light source is used in the above-described embodiment. However, the present invention is not limited in such a manner and other suitable light sources such as an $F_2$ laser light source may be used. When $F_2$ laser light is used as the exposure light, fluorine-containing liquid such as fluorine-based oils and perfluoropolyether (PFPE) that can transmit $F_2$ laser light is used as the liquid. In the above-described embodiment, the present invention is applied to a projection optical system used in an exposure apparatus. However, the present invention is not limited in such a manner and may be applied to other suitable liquid immersion projection optical systems of plural imaging types and refractive types.

**Claims**

1.  A projection optical system that forms a reduced image of a first plane on a second plane, the projection optical system including:

    a first imaging system, which is arranged in an optical path between a first plane and a conjugation point optically conjugated to a point on an optical path of the first plane;
    a second imaging system, which is arranged in an optical path between the conjugation point and the second plane;
    wherein optical elements having power in the projection optical system are all refractive optical elements;
    the projection optical system being **characterized in that** with gas in the optical path of the projection optical system having a refractive index of 1, the optical path between the projection optical system and the second plane is filled with liquid having a refractive index of 1.3 or greater.

2.  The projection optical system according to claim 1, being **characterized in that** the condition of $5 < |\beta 1 / \beta|$ is satisfied where $\beta 1$ represents an imaging magnification of the first imaging system and $\beta$ represents a projection magnification of the projection optical system.

3.  The projection optical system according to claim 1 or 2, being **characterized in that:**

    the projection optical element includes, sequentially from the first plane side, a first lens group having positive refractive power, a second lens group having negative refractive power, a third lens group having positive refractive power, a fourth lens group having negative refractive power, a fifth lens group having positive refractive power, a sixth lens group having negative refractive power, and a seventh lens group having positive refractive power.

4. The projection optical system according to claim 3, being **characterized in that** the conjugation point is located in an optical path between the third lens group and the seventh lens group.

5. The projection optical system according to claim 3 or 4, being **characterized in that:**

   when a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7, the conditions of:

$$4 < (D1 + D3) / D2;$$

$$3 < (D3 + D5) / D4;$$

$$4 < (D5 + D7) / D6$$

   and are satisfied.

6. The projection optical system according to any one of claims 3 to 5, being **characterized in that:**

   when a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7, the conditions of:

$$4.5 < (D1 + D3) / D2 < 8;$$

$$3 < (D3 + D5) / D4;$$

   and

$$4 < (D5 + D7) / D6$$

   are satisfied.

7. The projection optical system according to any one of claims 3 to 6, being **characterized in that:**

   when a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7, the conditions of:

$$4 < (D1 + D3) / D2;$$

$$3.3 < (D3 + D5) / D4 < 8;$$

and

$$4 < (D5 + D7) / D6$$

are satisfied.

8. The projection optical system according to any one of claims 3 to 7, being **characterized in that:**

when a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7, the conditions of:

$$4 < (D1 + D3) / D2;$$

$$3 < (D3 + D5) / D4;$$

and

$$4.5 < (D5 + D7) / D6 < 10$$

are satisfied.

9. The projection optical system according to claim 3 or 4, being **characterized in that:**

when a maximum clear aperture diameter of the first lens group is represented by D1, a minimum clear aperture diameter of the second lens group is represented by D2, a maximum clear aperture diameter of the third lens group is represented by D3, a minimum clear aperture diameter of the fourth lens group is represented by D4, a maximum clear aperture diameter of the fifth lens group is represented by D5, a minimum clear aperture diameter of the sixth lens group is represented by D6, and a maximum clear aperture diameter of the seventh lens group is represented by D7, the conditions of:

$$4 < (D1 + D3) / D2 < 8;$$

$$3 < (D3 + D5) / D4 < 8;$$

and

$$4 < (D5 + D7) / D6 < 10$$

are satisfied.

**10.** The projection optical system according to any one of claims 1 to 9, being **characterized in that** the condition of $5.5 < |\beta 1 / \beta|$ is satisfied where $\beta 1$ represents an imaging magnification of the first imaging system and $\beta$ represents a projection magnification of the projection optical system.

**11.** The projection optical system according to any one of claims 1 to 9, being **characterized in that** the condition of $5 < |\beta 1 / \beta| < 12$ is satisfied where $\beta 1$ represents an imaging magnification of the first imaging system and $\beta$ represents a projection magnification of the projection optical system.

**12.** The projection optical system according to any one of claims 1 to 9, being **characterized in that** the condition of $5.5 < |\beta 1 / \beta| < 12$ is satisfied where $\beta 1$ represents an imaging magnification of the first imaging system and $\beta$ represents a projection magnification of the projection optical system.

**13.** An exposure apparatus being **characterized by**:

the projection optical system according to any one of claims 1 to 12 which projects an image of a predetermined pattern set at the first plane onto a photosensitive substrate set at the second plane based on light from the pattern.

**14.** A device manufacturing method being **characterized by**:

an exposure step for exposing the predetermined pattern onto the photosensitive substrate using the exposure apparatus according to claim 13; and
a development step for developing the photosensitive substrate that has undergone the exposure step.

# Fig.1

# Fig.2

# Fig.3

# Fig.4

# Fig.5

Meridional            Sagittal

0.002    Y=13.7mm      0.002

−0.002                  −0.002

0.002    Y=7.0mm      0.002

−0.002                  −0.002

0.002    Y=0.0mm      0.002

−0.002                  −0.002(mm)

# Fig.6

# Fig.7

Meridional

Sagittal

0.002    Y=13.7mm    0.002

−0.002      −0.002

0.002    Y=7.0mm    0.002

−0.002      −0.002

0.002    Y=0.0mm    0.002

−0.002      −0.002(mm)

# Fig.8

# Fig.9

Meridional                    Sagittal

0.002          Y=14.0mm          0.002

−0.002                          −0.002


0.002          Y=7.0mm          0.002

−0.002                          −0.002


0.002          Y=0.0mm          0.002

−0.002                          −0.002(mm)

# Fig.10

```
            ┌─────────────────────┐
            │        START        │
            └─────────────────────┘
                        │
  ┌─────────────────────────────────────────────┐
  │   Vapor deposit metal film on wafer          │─S301
  └─────────────────────────────────────────────┘
                        │
  ┌─────────────────────────────────────────────┐
  │   Apply photoresist to the metal film        │─S302
  └─────────────────────────────────────────────┘
                        │
  ┌─────────────────────────────────────────────┐
  │   Transfer image of reticle pattern onto     │
  │        each shot region on wafer via         │─S303
  │   exposure apparatus of the embodiment       │
  └─────────────────────────────────────────────┘
                        │
  ┌─────────────────────────────────────────────┐
  │      Develop photoresist on wafer            │─S304
  └─────────────────────────────────────────────┘
                        │
  ┌─────────────────────────────────────────────┐
  │  Etch wafer using resist pattern as mask     │─S305
  └─────────────────────────────────────────────┘
                        │
            ┌─────────────────────┐
            │     Next step       │
            └─────────────────────┘
```

# Fig.11

```
              ┌─────────────────┐
              │      START      │
              └────────┬────────┘
                       │
     ┌─────────────────┴─────────────────┐
     │      Pattern formation step       │~S401
     └─────────────────┬─────────────────┘
                       │
     ┌─────────────────┴─────────────────┐
     │    Color filter formation step    │~S402
     └─────────────────┬─────────────────┘
                       │
     ┌─────────────────┴─────────────────┐
     │        Cell assembly step         │~S403
     └─────────────────┬─────────────────┘
                       │
     ┌─────────────────┴─────────────────┐
     │       Module assembly step        │~S404
     └─────────────────┬─────────────────┘
                       │
              ┌────────┴────────┐
              │       END       │
              └─────────────────┘
```

**EP 2 003 478 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004019128 A
- WO 9949504 A
- JP 10303114 A
- JP 8313842 A
- JP 2004304135 A